# EUROPÄISCHE PATENTSCHRIFT

(11) **EP 0 792 852 B1**
(45) Veröffentlichungstag und Bekanntmachung des Hinweises auf die Patenterteilung: **23.08.2000**
(21) Anmeldenummer: 97102486.4
(22) Anmeldetag: 15.02.1997
(51) Int. Cl.: C04B 35/46, C23C 14/08

(54) **Verfahren zur Herstellung stabilisierter Aufdampfmaterialien auf Basis von Titanoxid**
Process for the production of stabilized evaporation material based on titanium oxide
Procédé pour la préparation de matériaux stabilisés vaporisables à base d'oxyde de titane

(30) Priorität: 01.03.1996 DE 19607833
(43) Veröffentlichungstag der Anmeldung: 03.09.1997
(73) Patentinhaber: MERCK PATENT GmbH, 64293 Darmstadt (DE)
(72) Erfinder: Krähe, Karl-Friedrich, 64291 Darmstadt (DE)

(56) Entgegenhaltungen:
- GB-A- 2 281 741
- US-A- 4 912 286
- DATABASE WPI Week 9544 Derwent Publications Ltd., London, GB; AN 95-340446 XP002032497 & JP 07 233 469 A (ASAHI GLASS CO. LTD.) , 5.September 1995

## Beschreibung

Die Anmeldung betrifft ein Verfahren zur Herstellung von stabilisierten Aufdampfmaterialien für optische Anwendungen, welche einen Erhalt des Brechungsindex und der Transmissionseigenschaften des Substratmaterials erfordern sowie die Verwendung der stabilisierten Aufdampfmaterialien.

Es ist verbreiteter Stand der Technik, die Oberflächen von optischen Bauteilen mit dünnen Beschichtungen zu deren Schutz oder zur Erzielung bestimmter Funktionseigenschaften zu versehen. Als derartige optische Bauteile sind im wesentlichen optische Linsen, Brillengläser, Objektive für Kameras, Ferngläser oder für andere optische Geräte, Strahlenteiler, Prismen, Spiegel, Fensterscheiben usw. zu verstehen. Zum einen ist Ziel derartiger Beschichtungen, die Oberflächen von optischen Substraten dahingehend zu vergüten, daß durch Härtung und/oder Erhöhung der chemischen Resistenz Schädigungen durch mechanische, chemische oder Umwelteinflüsse vermieden werden. Dies steht im besonderen Maße bei Substraten aus Kunststoffmaterialien im Vordergrund. Zum anderen werden Oberflächenbeschichtungen zur Verminderung der Reflexion eingesetzt, insbesondere bei Brillengläsern und Objektiven. Hierbei kann bei geeigneter Wahl der Beschichtungsmaterialien, Schichtdicke, ein- oder mehrschichtigem Aufbau aus gegebenenfalls unterschiedlichen Materialien mit differierenden Brechungsindizes eine Reduktion der Reflexion auf unter 1 % über das gesamte sichtbare Strahlenspektrum erreicht werden.

Zur Erzeugung derartiger Vergütungs- bzw. Antireflexschichten dienen zahlreiche oxidische Materialien, wie etwa SiO₂, TiO₂, ZrO₂, MgO, Al₂O₃, auch Fluoride wie MgF₂ sowie Gemische dieser Stoffe. Die Beschichtung von optischen Substraten erfolgt üblicherweise in der Hochvakuumaufdampftechnik. Hierbei wird das Substrat und eine die Aufdampfsubstanz enthaltende Vorlage in eine entsprechende Hochvakuumaufdampfapparatur plaziert, anschließend wird die Apparatur evakuiert und dann die Substanz durch Erhitzen und/oder Elektronenstrahlverdampfung zu Verdampfung gebracht, wobei sich das Aufdampfmaterial auf der Substratoberfläche als dünne Schicht niederschlägt. Entsprechende Apparaturen und Verfahren sind gängiger Stand der Technik.

Aus US-A-4,912,286 ist ein leitfähiges Material bekannt, daß zur Herstellung von TiOₓ-Leitern verwendet wird, worin x die Bedeutung x = 1,7 bis 1,85 aufweist. Dieses Material wird aus einem pulverförmigen Titanoxid oder -suboxid hergestellt, indem es mit Wasser vermischt geformt gepresst und gesintert wird.

Titanoxid ist die am häufigsten eingesetzte Substanz zur Herstellung von dünnen Schichten mit hohem Brechungsindex durch Aufdampfen im Hochvakuum. Titanoxid-Schichten sind transparent im sichtbaren und im nahen infraroten Spektralbereich von etwa 360 nm bis 12 µm. Der Brechungsindex ist etwa 2,4 bei 500 nm. Deshalb werden Schichten aus Titanoxid für viele Schichttypen eingesetzt, z. B. für Filter, Strahlenteiler, Reflektoren, Polarisatoren und Antireflexschichten.

Titanoxid-Schichten können durch Verdampfen von Titan(IV)oxid, Titan(III)oxid und Titan(II)-oxid hergestellt werden. Besonders vorteilhaft ist ein Oxid mit der Zusammensetzung TiO_{1,7}. Dieses Oxid hat bereits die Zusammensetzung, die die Schmelze aus anderen Titanoxiden erst nach längerem Verdampfen annimmt. Besonders beim Einsatz von Titan(IV)-oxid ist ein zeitraubender Vorschmelz-Prozeß erforderlich, um eine Schmelze mit stabiler Zusammensetzung zu erhalten.

Das Titanoxid der Stöchiometrie TiO_{1,7} besteht röntgenographisch aus einer Mischung von Ti₃O₅ und Ti₄O₇.

Die für die Anwendung in der Aufdampftechnik günstigste Form ist je nach Anwendung verschieden. Meist werden Körner, Tabletten oder Pellets eingesetzt. In Pulverform vorliegende Substanzen sind weniger günstig, da es dabei in der Anwendung oft zum Spritzen während des Aufheizens und Einschmelzens kommt.

In JP 56083901 wird eine keramische Zusammensetzung beschrieben, bestehend aus einer gesinterten Mischung der Oxide des Zinns und Titans sowie ein oder mehrere Oxid(e) der Elemente Tantal, Antimon, Niob, Wolfram. Verwendet wird dieses Material als Widerstandsmaterial mit stabilen Feuchtigkeitsresistenz-Eigenschaften, die unabhängig von der Temperatur sind. Die optischen Eigenschaften dieses Materials sind für diese Anwendung ohne Bedeutung.

Die Suboxide von Titan, in denen dieses eine geringere Wertigkeit als IV aufweist, werden nach dem Stand der Technik aus homogenisierten Mischungen von Titan(IV)-oxid- und Titan-Pulver mit der entsprechenden Zusammensetzung hergestellt, indem die Mischungen im Hochvakuum gesintert werden. Die Sintertemperaturen liegen bei etwa 1300 bis 1700 °C. Der Restdruck liegt beim Sinterprozeeß unter 10⁻³ mbar. Die Form der Materialien wird vor dem Sintern durch Tablettieren, Granulieren oder Pelletieren hergestellt. Bei dem Sinterprozeß reagieren die Komponenten zu dem jeweiligen Suboxid. Für die Anwendung als Aufdampfmaterial geeignete Titansuboxide besitzen eine stöchiometrische Zusammensetzung entsprechend TiOₓ mit x = 1,5 bis 1,7.

Bei der Herstellung nach dieser Technik zeigt sich aber, daß die Körner, Tabletten oder Pellets sehr spröde sind und bei mechanischen Belastungen, z.B. beim Verpacken, beim Transport und beim Einfüllen in die Verdampfertiegel leicht zerstört werden, wobei sich größere Menge an sehr feinteiligem Pulver bilden. Dieses Pulver stört beim Aufdampfprozeß, indem es beim Einschmelzen und beim Verdampfen zu Spritzern führt, die auf die zu beschichtenden Teile, wie Scheiben, Linsen oder Prismen gelangen können und diese unbrauchbar machen.

Die geringe mechanische Stabilität der Titanoxide hat weiterhin den Nachteil, daß durch den Zerfall zu Pulver die Ausbeute beim Herstellprozeß erheblich reduziert wird. Erfahrungsgemäß entstehen bei der Herstellung von TiO_{1,7} bis zu 25 % Abfälle an feinem Pulver, das für die Anwendung in der Aufdampftechnik unbrauchbar ist.

Um diesen Nachteil zu eliminieren oder zu verringern, kann versucht werden, die Härte bzw. die Haltbarkeit der Körner, Tabletten oder Pellets zu erhöhen.

Eine Möglichkeit besteht darin, durch geeignete Wahl der Bedingungen beim Sinterprozeß die Haltbarkeit zu erhöhen. Es zeigt sich aber, daß haltbare Körner, Tabletten oder Pellets nur hergestellt werden können, wenn die Sintertemperatur relativ niedrig ist. Dabei ist aber die Reaktion zum Suboxid nicht vollständig, so daß noch Reste der Ausgangsstoffe TiO₂ bzw. Ti vorhanden sind. Beim Einschmelzen und Verdampfen in der Aufdampfanlage tritt starkes Spritzen auf, so daß das Material nicht brauchbar ist. Für die Herstellung von Material, das beim Einschmelzen und Verdampfen nicht spritzt, ist eine Mindesttemperatur erforderlich, ab der die Körner, Tabletten oder Pellets jedoch brüchig werden. Bei weiterer Erhöhung der Sintertemperatur können die Körner, Tabletten oder Pellets bereits im Sinterprozeß zerfallen.

Auch der Versuch, die Haltbarkeit der Körner, Tabletten oder Pellets dadurch zu verbessern, daß die Härte beim Tabletten, Granulieren oder Tablettieren erhöht wird, ist nicht erfolgreich. Die Körner, Tabletten oder Pellets werden nämlich beim Sintervorgang wieder spröde und instabil.

Dieser Effekt kommt dadurch zustande, daß die Kristallite der Suboxide beim Sintervorgang bis in die Größenordnung 0,01 bis 0,1 mm wachsen und den Zusammenhalt der Kristallite stören.

Dem erfindungsgemäßen Verfahren lag daher die Aufgabe zugrunde, durch einen Zusatz die Struktur der Materialien zu verbessern.

In Frage kommen nur anorganische Zusatzstoffe. Organische Bindemittel werden beim Sinterprozeß zerstört und verdampft, sind also für die Stabilisierung nicht geeignet. Anorganische Zusatzstoffe verbleiben in dem Material. Sie sind daher so auszuwählen, daß sie zwar die Härte und Haltbarkeit des Produkts verbessern, die anderen Eigenschaften aber nicht verschlechtern. Insbesondere ist darauf zu achten, daß die optischen Eigenschaften der Schichten, insbesondere Brechungsindex und Transmissionsbereich, nicht verändert werden. Im Gegensatz dazu wird durch das in JP-A-07233469 beschriebene Verfahren die Herstellung eines Films mit hohem Brechungsindex angestrebt. Als Hauptkomponente wird zur Herstellung des Films TiOₓ mit x größer 1 kleiner 2 verwendet. Neben dem optischen Brechungsindex darf auch das Verhalten beim Verdampfen nicht verschlechtert werden, insbesondere durch etwaiges Ausgasen und Spritzen beim Einschmelzen und Verdampfen.

Weiter soll der Zusatzstoff sich beim Verdampfen in der Schmelze nicht anreichern oder abreichern, sondern kongruent mit dem Titanoxid verdampfen. Sonst ändert sich die Zusammensetzung des Verdampfungsmaterials im Laufe der Verdampfung und die optischen Eigenschaften der Aufdampfschichten sind nicht konstant bzw. nicht reproduzierbar.

Umfangreiche Versuche haben ergeben, daß eine größere Zahl von Oxiden, wie etwa die von Calcium, Magnesium, Aluminium, Silicium, Niob, Tantal, Cer, Praseodym, Vanadium, Chrom und Eisen wegen nicht ausreichender Stabilisierungswirkung, inkongruenter Verdampfung, Gasabgabe beim Einschmelzen oder Absorption im sichtbaren bis ultravioletten Spektralbereich als stabilisierende Zusätze nicht geeignet sind.

Überraschend wurde nun gefunden, daß sich Oxide aus der Gruppe Zirkonoxid, Hafniumoxid, Yttriumoxid und Ytterbiumoxid vorzüglich als stabilisierende Zusätze für gesinterte Aufdampfmaterialien auf Basis von Titanoxid eignen.

Gegenstand der Erfindung ist somit ein Verfahren zur Herstellung von stabilisierten Aufdampfmaterialien für optische Anwendungen, welche einen Erhalt des Brechungsindex und der Transmissionseigenschaften des Substratmaterials erfordern, durch Sintern im Hochvakuum eines feinteiligen Gemischs von Titanoxiden und gegebenenfalls metallischen Titans, das eine stöchiometrische Zusammensetzung entsprechend TiOₓ mit x = 1,4 bis 1,8 aufweist, zusammen mit 0,1 bis 10 Gew.-% eines Oxids aus der Gruppe Zirkonoxid, Hafniumoxid, Yttriumoxid und Ytterbiumoxid bei Temperaturen zwischen 1300 und 1700 °C.

Die erfindungsgemäße Herstellung von stabilisierten gesinterten Aufdampfmaterialien für optische Anwendungen erfolgt auf Basis von Titanoxid, wobei das Titanoxid die Zusammensetzung TiOₓ mit x = 1,4 bis 1,8 , bevorzugt x= 1,5 bis 1,7, vorzugsweise mit x= 1,7, aufweist, und die Zusammensetzung 0,1 bis 10 Gew.-%, bevorzugt 0,5 bis 5 Gew.-%, vorzugsweise etwa 2,5 Gew.-%, eines Oxides aus der Gruppe Zirkonoxid, Hafniumoxid, Yttriumoxid oder Ytterbiumoxid enthält.

Beider erfindungsgemäßen Herstellung stabilisierter, gesinternter Aufdampfmaterialien auf Basis von Titanoxid hat das Titanoxid die Zusammensetzung TiOₓ mit x=1,4 bis 1,8. Erfindungsgemäß enthalten die Aufdampfmaterialien 0,1 bis 10 Gew.-% eines Oxides aus der Gruppe Zirkonoxid (ZrO₂), Hafniumoxid (HfO₂), Yttriumoxid (Y₂O₃) und Ytterbiumoxid (Yb₂O₃) als stabilisierenden Zusatz in homogener Verteilung. Vorzugsweise sind 0,5 bis 5 Gew.-% und insbesondere etwa 2,5 Gew.-% an diesen Oxiden in den Aufdampfmaterialien enthalten. Bevorzugte Aufdampfmaterialien enthalten Titanoxid der Zusammensetzung TiOₓ mit x=1,5 bis 1,7 , wobei x=1,7 besonders bevorzugt ist. Von den als stabilisierenden Zusatz einzusetzenden Oxiden ist Zirkonoxid (ZrO₂) besonders bevorzugt.

Gegenstand der vorliegenden Erfindung ist auch die Verwendung der hergestellten stabilisierten gesinterten Aufdampfmaterialien zur Herstellung dünner optischer Schichten, welche keine meßbare Absorption im Spektralbereich von 360nm bis 5 µm aufweisen.

Es hat sich gezeigt, daß der Zusatz der genannten Oxide eine unerwartete mechanische Stabilisierung von Sinterprodukten auf Basis von Titanoxid bewirkt. So kommt es beim Sintern von entsprechenden Formkörpern, wie Körnern, Tabletten oder Pellets, bei Temperaturen, die die Umsetzung zu Titansuboxiden einheitlicher und stabiler stöchiometrischer Zusammensetzung bewirken, nicht mehr zum Zerfall der Sinterprodukte. Weiterhin sind die Sinterkörper hart und gegen mechanische Belastung dauerhaft stabil. Bei der weiteren Handhabung als Aufdampfmaterial, etwa bei Verpackung, Lagerung und Versand sowie bei der Anwendung im Aufdampfprozeß, entsteht kein Bruch oder Abrieb von feinteiligem Pulver.

Im erfindungsgemäßen Verfahren zur Herstellung Stabilisierter Aufdampfmaterialien wird dem Ausgangsgemisch die entsprechende Menge an als Stabilisator wirkendem Oxid zugefügt. Im einzelnen wird zunächst ein feinteiliges homogenes Gemisch von Titanoxid oder Titanoxiden und/oder metallischem Titan, wobei die Zusammensetzung so gewählt ist, daß sie TiOₓ mit x = 1,4 bis 1,8 entspricht, und 0,1 bis 10 Gew.-% eines Oxides aus der Gruppe Zirkonoxid, Hafniumoxid, Yttriumoxid und Ytterbiumoxid zubereitet. Dieses Gemisch wird in üblicher Technik durch Granulieren, Pelletieren oder Tablettieren zu entsprechenden Formkörpern verarbeitet. Diese werden dann im Hochvakuum bei Temperaturen zwischen 1300 und 1700 °C gesintert. Die Sinterdauer kann je nach Wahl der Temperatur zwischen 12 und 48 Stunden betragen. Günstig ist die Sinterung bei 1500 °C über 24 Stunden.

Im Herstellprozeß und bei der weiteren Handhabung ist bei dem erfindungsgemäß stabilisierten Aufdampfmaterial ein Feinanteil von weniger als 1 % zu verzeichnen. Im Vergleich entsteht bei nicht stabilisiertem Material bereits im Herstellprozeß ein Feinanteil von in der Regel etwa 20%.

Die nach dem erfindungsgemäßen Verfahren hergestellten stabilisierten Aufdampfmaterialien sind vorteilhaft in völliger Analogie zu üblichen Titanoxidaufdampfmaterialien bei der Herstellung dünner Schichten in der Hochvakuumaufdampftechnik zu verwenden. Beim Einschmelzen und Verdampfen tritt kein Spritzen und Ausgasen auf. Weiterhin zeigt sich, daß die als Stabilisierungszusatz enthaltenen Oxide sich in der Restschmelze nicht anreichern. Das heißt, daß das Material kongruent, also mit gleichbleibender Zusammensetzung verdampft. Die erzeugten Schichten sind dementsprechend in ihrer Zusammensetzung und folglich in ihren Eigenschaften, wie etwa Brechungsindex, konstant und reproduzierbar. Dies ist wichtig, wenn neues Material zu einer Schmelze nachgefüllt werden muß oder aus einer Schmelze mehrmals nacheinander Schichten hergestellt werden sollen.

Die aus nach dem erfindungsgemäßen Verfahren gewonnenen Aufdampfmaterialien hergestellten Schichten weisen keine meßbaren Absorptionen im Spektralbereich von 360 nm bis etwa 5 µm auf.

### Beispiel 1:

Eine homogene feinteilige Mischung, bestehend aus 89,53 % Titandioxid, 9,47 % Titan und 1 % Zirkonoxid wird granuliert und im Vakuum bei einem Restdruck unter 1 · 10⁻³ mbar gesintert. Die Sintertemperatur beträgt 1500 °C, die Sinterdauer 24 Stunden.

Die erhaltenen gesinterten Körner sind hart und haltbar. Beim Entnehmen aus der Anlage, beim Verpacken und beim Einsatz in der Aufdampfanlage entstehen nur sehr geringe Mengen an Feinteilen (unter 1 %).

### Beispiel 2:

Eine Mischung, bestehend aus 88,625 % Titandioxid, 9,375 % Titan und 2 % Zirkonoxid wird granuliert und im Vakuum bei einem Restdruck unter 1 · 10⁻³ mbar gesintert. Die Sintertemperatur beträgt 1500 °C, die Sinterdauer 24 Stunden.

Auch diese Mischung ergibt harte und haltbare Körner.

### Beispiel 3: Schichtherstellung

In einer handelsüblichen Aufdampfanlage (A700Q der Fa. Leybold, Hanau) wird ein wassergekühlter Kupfertiegel der Elektronenstrahlverdampfer-Einrichtung mit Material gemäß Beispiel 1 gefüllt. Gereinigte Substrate aus Quarzglas werden auf der Substrathaltevorrichtung befestigt. Die Anlage wird geschlossen und auf einen Druck unter 1 · 10⁻⁵ mbar evakuiert. Die Substrate werden auf etwa 300 °C beheizt. Mit Hilfe einer Gaseinlaßvorrichtung wird Sauerstoff bis zu einem Druck von etwa 2 · 10⁻⁴ mbar eingelassen. Das Aufdampfmaterial wird unter einer Abdeckblende langsam aufgeheizt und eingeschmolzen. Die Blende wird geöffnet und das Titanoxid wird mit einer Geschwindigkeit von 0,2 nm/s auf die Substrate aufgedampft, bis die gewünschte Schichtdicke erreicht ist. Die auf diese Weise hergestellten Schichten sind transparent im Spektralbereich von 380 nm bis über 5 µ. Der Brechungsindex bei 500 nm ist etwa 2.2.

## Patentansprüche

1. Verfahren zur Herstellung von stabilisierten Aufdampfmaterialien für optische Anwendungen, welche einen Erhalt des Brechungsindex und der Transmissionseigenschaften des Substratmaterials erfordern, durch Sintern im Hochvakuum eines feinteiligen Gemischs von Titanoxiden und gegebenenfalls metallischen Titans, das eine stöchiometrische Zusammensetzung entsprechend
TiOₓ mit x = 1,4 bis 1,8 aufweist, zusammen mit 0,1 bis 10 Gew.-% eines Oxids aus der Gruppe Zirkonoxid, Hafniumoxid, Yttriumoxid und Ytterbiumoxid bei Temperaturen zwischen 1300 und 1700 °C.

2. Verfahren zur Herstellung von stabilisierten gesinterten Aufdampfmaterialien gemäß Anspruch 1 für optische Anwendungen auf Basis von Titanoxid, wobei das Titanoxid die Zusammensetzung TiOₓ mit x = 1,4 bis 1,8 aufweist, dadurch gekennzeichnet, daß diese 0,1 bis 10 Gew.-% eines Oxides aus der Gruppe Zirkonoxid, Hafniumoxid, Yttriumoxid oder Ytterbiumoxid enthalten.

3. Verfahren zur Herstellung von stabilisierten gesinterten Aufdampfmaterialien gemäß Anspruch 1 für optische Anwendungen, dadurch gekennzeichnet, daß diese 0,5 bis 5 Gew.-%, vorzugsweise etwa 2,5 Gew.-%, an Oxiden aus der Gruppe Zirkonoxid, Hafniumoxid, Yttriumoxid und Ytterbiumoxid enthalten.

4. Verfahren zur Herstellung von stabilisierten gesinterten Aufdampfmaterialien gemäß Anspruch 1 für optische Anwendungen, dadurch gekennzeichnet, daß das Titanoxid die Zusammensetzung TiOₓ mit x= 1,5 bis 1,7, vorzugsweise mit x= 1,7, aufweist.

5. Verwendung der gemäß der Ansprüche 1 - 4 hergestellten stabilisierten gesinterten Aufdampfmaterialien zur Herstellung dünner optischer Schichten, dadurch gekennzeichnet, daß sie keine meßbare Absorption im Spektralbereich von 360nm bis 5 µm aufweisen.

## Claims

1. Process for preparing stabilized vapour-deposition materials for optical applications requiring retention of the refractive index and of the transmission properties of the substrate material by high-vacuum sintering of a finely divided mixture of titanium oxides and optionally metallic titanium having a stoichiometric composition TiOₓ where x = 1.4 to 1.8 together with from 0.1 to 10% by weight of an oxide from the group consisting of zirconium oxide, hafnium oxide, yttrium oxide and ytterbium oxide at temperatures of between 1300 and 1700°C.

2. Process for preparing stabilized sintered vapour-deposition materials according to Claim 1 for optical applications based on titanium oxide, the titanium oxide having the composition TiOₓ where x = 1.4 to 1.8, characterized in that the said materials contain from 0.1 to 10% by weight of an oxide from the group consisting of zirconium oxide, hafnium oxide, yttrium oxide and ytterbium oxide.

3. Process for preparing stabilized sintered vapour-deposition materials according to Claim 1 for optical applications, characterized in that the said materials contain from 0.5 to 5% by weight, preferably about 2.5% by weight, of oxides from the group consisting of zirconium oxide, hafnium oxide, yttrium oxide and ytterbium oxide.

4. Process for preparing stabilized sintered vapour-deposition materials according to Claim 1 for optical applications, characterized in that the titanium oxide has the composition TiOₓ where x = 1.5 to 1.7, preferably where x = 1.7.

5. Use of the stabilized sintered vapour-deposition materials prepared according to Claims 1 - 4 for producing thin optical layers, characterized in that they have no measurable absorption in the spectral range from 360 nm to 5 µm.

## Revendications

1. Procédé pour la préparation de matériaux stabilisés à évaporer destinés à une utilisation optique nécessitant un maintien de l'indice de réfraction et des propriétés de transmission du substrat, par frittage sous un vide poussé d'un mélange finement divisé d'oxydes de titane et éventuellement de titane métallique, présentant une composition stoechiométrique correspondant à TiOₓ, x étant compris entre 1,4, et 1,8, avec 0,1 à 10 % en poids d'un oxyde du groupe constitué par l'oxyde de zirconium, l'oxyde d'hafnium, l'oxyde d'yttrium et l'oxyde d'ytterbium à des températures comprises entre 1 300 et 1 700°C.

2. Procédé pour la préparation de matériaux frittés stabilisés à évaporer selon la revendication 1 destinés à une utilisation optique à base d'oxyde de titane, l'oxyde de titane présentant la composition TiOₓ, x étant compris entre 1,4 et 1,8, caractérisé en ce que ceux-ci contiennent 0,1 à 10 % en poids d'un oxyde du groupe constitué par l'oxyde de zirconium, l'oxyde d'hafnium, l'oxyde d'yttrium ou l'oxyde d'ytterbium.

3. Procédé pour la préparation de matériaux frittés stabilisés à évaporer selon la revendication 1 destinés à une utilisation optique, caractérisé en ce que ceux-ci contiennent 0,5 à 5 % en poids, de préférence, environ 2,5 % en poids d'un oxyde du groupe constitué par l'oxyde de zirconium, l'oxyde d'hafnium, l'oxyde d'yttrium et l'oxyde d'ytterbium.

4. Procédé pour la préparation de matériaux frittés stabilisés à évaporer selon la revendication 1 destinés à une utilisation optique, caractérisé en ce que l'oxyde de titane présente la composition Tioₓ, x étant compris entre 1,5 et 1,7, de préférence x étant égal à 1,7.

5. Utilisation des matériaux frittés stabilisés à évaporer préparés selon les revendications 1 à 4 pour la réalisation de couches optiques minces, caractérisé en ce qu'ils ne présentent pas d'absorption mesurable dans un domaine spectral allant de 360 à 5 µm.
